# EUROPEAN PATENT SPECIFICATION

(11) **EP 2 966 766 B1**
(45) Date of publication and mention of the grant of the patent: **24.04.2019**
(21) Application number: 13877209.0
(22) Date of filing: 08.03.2013
(51) Int. Cl.: H02M 7/48, B60L 3/00, H01L 29/16, H05K 7/20

(54) **POWER CONVERTER FOR VEHICLE**
LEISTUNGSWANDLER FÜR EIN FAHRZEUG
CONVERTISSEUR DE PUISSANCE POUR VÉHICULE

(43) Date of publication of application: 13.01.2016
(73) Proprietor: Kabushiki Kaisha Toshiba, Minato-ku Tokyo 105-8001 (JP)
(72) Inventor: TODA, Shinichi, Tokyo 105-8001 (JP); YASUOKA, Ikuo, Tokyo 105-8001 (JP); FUJITO, Haruhiko, Tokyo 105-8001 (JP)
(74) Representative: AWA Sweden AB
(86) International application number: PCT/JP2013/056524
(87) International publication number: WO 2014/136271

(56) References cited:
- EP-A1- 1 947 756
- EP-A2- 2 456 054
- WO-A1-2008/001413
- WO-A1-2008/152686
- JP-A- 2000 102 253
- JP-A- 2001 192 180
- JP-A- 2002 095 268
- JP-A- 2005 033 885
- JP-A- 2005 117 819
- JP-A- 2005 328 651
- JP-A- 2007 185 026
- JP-A- 2009 072 049
- JP-A- 2011 229 372
- JP-A- 2012 075 317

## Description

### FIELD

Embodiments described herein relate generally to a power converter for a vehicle.

### BACKGROUND

Conventionally, Si insulated gate bipolar transistor (IGBT) modules for 1,500 A have been practically used in power converters for a vehicle such as variable voltage variable frequency (VVVF) inverters for a railway vehicle. When an inverter is constituted for 1,500 A using the Si IGBT modules (element modules), the current rating of the element module is about 1,500 A per one element module for 3.3 kV, and six element modules are mounted in an inverter that drives four induction motors (IMs) in parallel, which are generally used for railway vehicles, thereby constituting a three-phase inverter. For inverters for driving permanent magnet synchronous motors (PMSMs), which have recently been practically used, the PMSM requires one three-phase inverter for each motor. For this reason, although four inverters are required to drive four motors, a required current rating for one inverter is as low as about 500 A. Given these circumstances, a 2in1 element module, in which two IGBTs and diodes are mounted in one element module, is constituted, one inverter is constituted using three element modules, and four inverters, or a total of 12 2in1 element modules, are mounted on one cooler in a planar manner to constitute a 4in1 inverter.

However, in both the inverter for IM and the inverter for PMSM in the above-described conventional technologies, the element modules are mounted on the cooler in a planar manner, and the outer size of the inverter is largely dependent on the size of an area occupied by the element modules. Given this situation, the current constitution using the Si IGBT modules has limitation in downsizing. In EP197756A1 bus bars for power supply which extend from the U-, V-, and W-phase arms of an inverter toward a terminal base are disclosed. EP2456054A2 teaches an inverter comprising switching devices that include SiC MOSFETs. JP2009072049A teaches an inverter comprising a gate control device. JP2005117819A teaches a power conversion apparatus comprising an inverter device. JP2005328651A teaches a power converter that comprises a control circuit for controlling a switching element by outputting a control signal to a driver circuit, and a connecting conductor. Further, in JP2005328651A the control circuit (incorporated into the drive control circuit board) is spaced apart from the switching element, and connected to the switching element via a wiring for the drive control circuit board and the connecting conductor.

### BRIEF DESCRIPTION OF DRAWINGS

FIG. 1 is a diagram illustrating an example of a circuit configuration of a power converter for a vehicle according to a first embodiment,
FIG. 2 is a diagram exemplifying mounting of semiconductor element modules on a cooling unit;
FIG. 3 is a diagram exemplifying a side face when the semiconductor element modules are mounted on the cooling unit;
FIG. 4 is a diagram illustrating an example of a circuit configuration of a power converter for a vehicle according to a second embodiment;
FIG. 5 is a diagram illustrating mounting of semiconductor element modules on a cooling unit;
FIG. 6 is a IV-IV sectional view in FIG. 5;
FIG. 7 is a diagram illustrating an example of a circuit configuration of a power converter for a vehicle according to a third embodiment;
FIG. 8 is a diagram illustrating mounting of semiconductor element modules on a cooling unit;
FIG. 9 is a V-V sectional view in FIG. 8;
FIG. 10 is a diagram illustrating an example of a circuit configuration of a power converter for a vehicle according to a fourth embodiment;
FIG. 11 is a diagram exemplifying an appearance of a power converter for a vehicle according to Modification 1;
FIG. 12 is a VIa-VIa sectional view in FIG. 11;
FIG. 13 is a VIb-VIb sectional view in FIG. 11;
FIG. 14 is a VIc-VIc sectional view in FIG. 11;
FIG. 15 is a conceptual diagram exemplifying connection to a terminal unit;
FIG. 16 is a side view from the C direction in FIG. 15;
FIG. 17 is a VII-VII sectional view in FIG. 15;
FIG. 18 is a diagram exemplifying an appearance of a power converter for a vehicle according to Modification 2;
FIG. 19 is an VIII-VIII sectional view in FIG. 18 when being resin-sealed with a mold resin;
FIG. 20 is a diagram exemplifying an appearance of a power converter for a vehicle according to Modification 3;
FIG. 21 is a IXa-IXa sectional view in FIG. 20;
FIG. 22 is a IXb-IXb sectional view in FIG. 20;
FIG. 23 is a conceptual diagram exemplifying connection to a conductor receiver.

### DETAILED DESCRIPTION

The invention is defined by the features of claim 1.

The following describes power converters for a vehicle according to embodiments in detail with reference to the attached drawings. In the embodiments and modifications thereof described below, similar components will be attached with common symbols, and any duplicated description will be omitted.

### First Embodiment

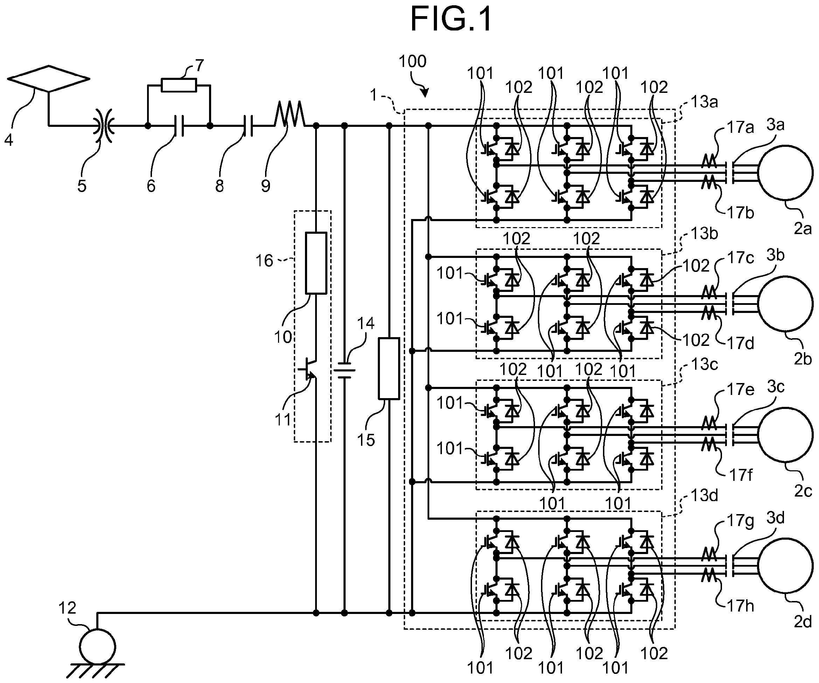

FIG. 1 is a diagram illustrating an example of a circuit configuration of a power converter 100 for a vehicle according to a first embodiment. As illustrated in FIG. 1, the power converter 100 for a vehicle has a circuit configuration that performs three-phase AC output for independently driving permanent magnet synchronous motors 2a to 2d by power from DC overhead electricity (not illustrated) and has a configuration of what is called 1C4M (C: controller; M: motor) that drives four motors.

A main circuit configuration of the power converter 100 for a vehicle includes a pantograph 4, a high-speed breaker 5, a charging resistor short-circuiting contactor 6, an open contactor 8, a filter reactor 9, a filter capacitor 14, a filter capacitor voltage detector 15, a filter capacitor discharge unit 16 (including a filter capacitor discharge resistor 10 and a switching element 11 for discharge), 6in1 semiconductor element modules 13a, 13b, 13c, and 13d, a cooling unit 1 that cools the semiconductor element modules, a wheel 12, the permanent magnet synchronous motors 2a, 2b, 2c, and 2d, motor open contactors 3a, 3b, 3c, and 3d, and current detectors 17a, 17b, 17c, 17d, 17e, 17f, 17g, and 17h.

Specifically, the pantograph 4 that collects electricity from the DC overhead electricity is connected to the high-speed breaker 5, and the high-speed breaker 5 is connected to the charging resistor short-circuiting contactor 6. The charging resistor short-circuiting contactor 6 is connected to a charging resistor 7 in parallel and is connected to the open contactor 8. The open contactor 8 is connected to the filter reactor 9. The filter reactor 9 is connected to one ends of the semiconductor element modules 13a, 13b, 13c, and 13d in the power converter 100 for a vehicle. The other ends of the semiconductor element modules 13a, 13b, 13c, and 13d are connected to the wheel 12.

One terminal of the filter capacitor discharge unit 16 is connected to between the filter reactor 9 and the semiconductor element modules 13a, 13b, 13c, and 13d, whereas the other terminal thereof is connected to between the wheel 12 and the semiconductor element modules 13a, 13b, 13c, and 13d. Both ends of the filter capacitor 14 are connected to between the filter capacitor discharge unit 16 and the semiconductor element modules 13a, 13b, 13c, and 13d.

On the three-phase AC output side output from the semiconductor element modules 13a, 13b, 13c, and 13d, the current detectors 17a, 17b, 17c, 17d, 17e, 17f, 17g, and 17h are provided, and the permanent magnet synchronous motors 2a, 2b, 2c, and 2d are connected via the motor open contactors 3a, 3b, 3c, and 3d, respectively.

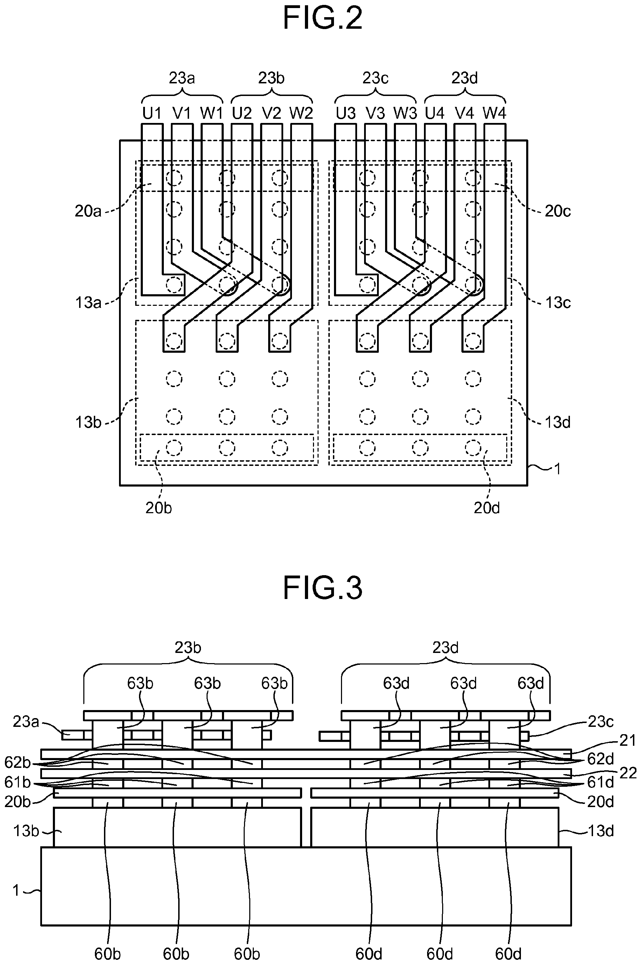

The semiconductor element modules 13a, 13b, 13c, and 13d include switching elements 101 that perform switching operation based on voltages applied to gates by gate driver circuit boards 20a, 20b, 20c, and 20d (refer to FIGS. 2 and 3) and freewheeling diodes 102 that pass a freewheeling current. Specifically, the semiconductor element modules 13a, 13b, 13c, and 13d have circuits for three phases, each of the circuits being related to single-phase AC output and having arms each of which connects the freewheeling diode 102 anti-parallel to the switching element 101, the arms being connected in series. In other words, each of the semiconductor element modules 13a, 13b, 13c, and 13d has a circuit that performs three-phase AC output for driving one permanent magnet synchronous motor (2a, 2b, 2c, and 2d) and has a configuration of 6in1 that incorporates six switching elements 101 into one circuit module. The semiconductor element modules 13a, 13b, 13c, and 13d with a configuration of 6in1 are mounted on the cooling unit 1.

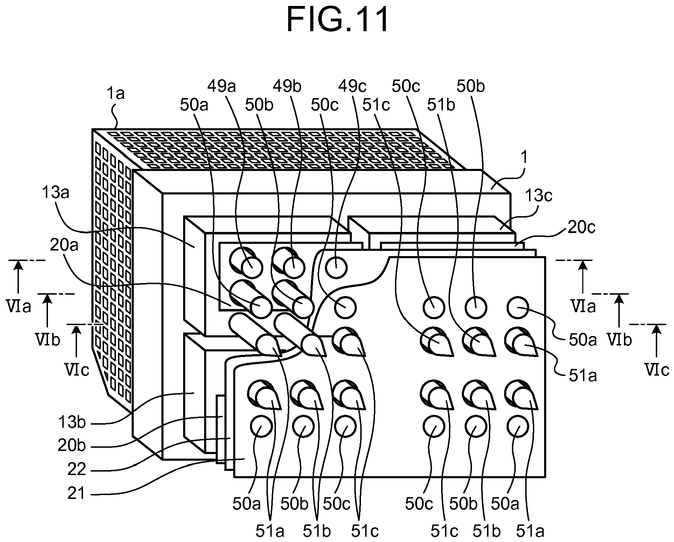

The cooling unit 1 radiates heat generated by the semiconductor element modules 13a, 13b, 13c, and 13d from a heat radiating unit 1a (refer to FIG. 11) through a coolant or the like, thereby cooling the semiconductor element modules 13a, 13b, 13c, and 13d.

Silicon carbide (SiC), not Si, is included in the switching elements 101 and the freewheeling diodes 102.

SiC is superior in semiconductor characteristics to conventional Si and, due to its high dielectric breakdown strength in particular, can achieve an element having a thinner semiconductor junction, that is, an element having smaller conduction losses than that including Si.

When the switching element 101 and the freewheeling diode 102 are used for power conversion, they have large heating values, and they are required to be cooled. While a semiconductor including Si has an allowable temperature of 125°C to 150°C, a semiconductor including SiC has an allowable temperature of 200°C to 250°C, by which an element can be used at higher temperatures. Consequently, by using SiC for the switching element 101 and the freewheeling diode 102, the cooling unit 1 can be simplified compared with a case of using Si.

When SiC is included in the switching element 101, switching losses occurring at the time of switching can be reduced. When SiC is included in the freewheeling diode 102, reverse recovery at the time of turning off as in conventional Si is reduced, and diode recovery losses can nearly be neglected. Consequently, there are the advantages that the power losses of the power converter 100 for a vehicle are reduced and that efficiency enhancement and downsizing of the apparatus can be achieved.

As compared with a Si IGBT module for 1,500 A, for example, when a wafer material is changed from Si to SiC, the thickness of chip junctions inside the semiconductor element modules 13a, 13b, 13c, and 13d can be reduced by one digit or more, and on resistance per unit area can be reduced. In other words, current density can be increased. Using SiC can practically increase current density at least twice the case of using Si. Consequently, by using SiC for the switching element 101 and the freewheeling diode 102, a chip having a larger current rating can be manufactured even with the same chip size. Consequently, also as the semiconductor element modules 13a, 13b, 13c, and 13d, modules having a larger current rating can be manufactured even with the same size as that of the Si IGBT.

Given this situation, using SiC for the switching element 101 and the freewheeling diode 102 can increase current density about twice the case of using Si, and simply even an inverter with the same current rating can halve the area occupied by the semiconductor element modules 13a, 13b, 13c, and 13d mounted on the cooling unit 1.

Considering that element modules including Si with a rating of 1,500 A are already put into practical use and that using SiC for the switching element 101 and the freewheeling diode 102 doubles their current density, an element module including SiC with a rating of 3,000 A can be constituted with the external shape identical to that of an element module including Si with a rating of 1,500 A. When an element rating for driving one motor is about 500 A as in PMSM drive, up to six elements with a current rating of 500 A can be incorporated into one element module. Consequently, based on the fact that a three-phase inverter provides the switching elements 101 on the positive electrode side and the negative electrode side of the respective phases, by packaging the six switching elements 101 in one module, an inverter that causes one of the semiconductor element modules 13a, 13b, 13c, and 13d to drive one of the permanent magnet synchronous motors 2a, 2b, 2c, and 2d can be constituted, and thus downsizing of the inverter can be achieved.

FIG. 2 is a diagram exemplifying mounting of the semiconductor element modules 13a, 13b, 13c, and 13d on the cooling unit 1. FIG. 3 is a diagram exemplifying a side face (when viewed from below in FIG. 2) when the semiconductor element modules 13a, 13b, 13c, and 13d are mounted on the cooling unit 1.

As illustrated in FIG. 2 and FIG. 3, the semiconductor element modules 13a, 13b, 13c, and 13d are arranged on the same cooling face (the top face of the cooling unit 1 in the illustrated example) that the cooling unit 1 provides cooling. On the semiconductor element modules 13a, 13b, 13c, and 13d, the gate driver circuit boards 20a, 20b, 20c, and 20d, a positive electrode side laminate conductor 21, and a negative electrode side laminate conductor 22 are arranged in substantially parallel to the semiconductor element modules 13a, 13b, 13c, and 13d. The semiconductor element modules 13a, 13b, 13c, and 13d, the gate driver circuit boards 20a, 20b, 20c, and 20d, the positive electrode side laminate conductor 21, the negative electrode side laminate conductor 22, and AC side output terminal conductors 23a, 23b, 23c, and 23d are connected to each other via connecting bushes.

Specifically, as illustrated in FIG. 3, the semiconductor element module 13b and the gate driver circuit board 20b are connected to each other via a connecting bush 60b. The semiconductor element module 13b and the negative electrode side laminate conductor 22 are connected to each other via a connecting bush 61b. The semiconductor element module 13b and the positive electrode side laminate conductor 21 are connected to each other via a connecting bush 62b. The semiconductor element module 13b and the AC side output terminal conductor 23b are connected to each other via a connecting bush 63b. Similarly, the semiconductor element module 13d and the gate driver circuit board 20d, the semiconductor element module 13d and the negative electrode side laminate conductor 22, the semiconductor element module 13d and the positive electrode side laminate conductor 21, and the semiconductor element module 13d and the AC side output terminal conductor 23d are connected to each other via connecting bushes 60d, 61d, 62d, and 63d, respectively. It is apparent that the semiconductor element modules 13a and 13c are also, similarly, connected via connecting bushes.

The AC side output terminal conductors 23a, 23b, 23c, and 23d are conductors that perform three-phase output to the permanent magnet synchronous motors 2a, 2b, 2c, and 2d. The AC side output terminal conductor 23a performs three-phase AC output of (U1, V1, W1) to the permanent magnet synchronous motor 2a. The AC side output terminal conductor 23b performs three-phase AC output of (U2, V2, W2) to the permanent magnet synchronous motor 2b. The AC side output terminal conductor 23c performs three-phase AC output of (U3, V3, W3) to the permanent magnet synchronous motor 2c. The AC side output terminal conductor 23d performs three-phase AC output of (U4, V4, W4) to the permanent magnet synchronous motor 2d.

The gate driver circuit boards 20a, 20b, 20c, and 20d are thus directly connected to the semiconductor element modules 13a, 13b, 13c, and 13d, respectively, via the connecting bushes, thereby reducing gate control wiring and increasing the responsiveness of gate control. The positive electrode side laminate conductor 21 and the negative electrode side laminate conductor 22 are connected to the semiconductor element modules 13a, 13b, 13c, and 13d via the connecting bushes to share the positive electrode side laminate conductor 21 and the negative electrode side laminate conductor 22 by the four element modules, thereby reducing inductance with the filter capacitor 14 and increasing cutoff characteristics in the switching element 101.

In this situation, the gate driver circuit boards 20a and 20c of the semiconductor element modules 13a and 13c are arranged side-by-side on one end of the cooling unit 1. The gate driver circuit boards 20b and 20d of the semiconductor element modules 13b and 13d are arranged side-by-side on the end opposite to the one end. With this configuration, terminals connected to the AC side output terminal conductors 23a, 23b, 23c, and 23d concentrate in the central part of the cooling unit 1. The connecting parts between the respective AC side output terminal conductors 23 and the respective semiconductor element modules are brought close to each other, thereby making the lengths of the conductors nearly the same and also making inductances, which are proportional to the length of the conductor, nearly the same, and malfunction in terms of control caused by differences in inductance can be reduced.

In this situation, the AC side output terminal conductor 23a has a substantially L shape and extends from the left side of FIG. 2 of the semiconductor element module 13a. The AC side output terminal conductor 23c has a substantially L shape and extends from the left side of FIG. 2 of the semiconductor element module 13c. The AC side output terminal conductor 23b has a shape bilateral symmetrical with a substantially L shape and extends from the right side of FIG. 2 of the semiconductor element module 13a. The AC side output terminal conductor 23d has a shape bilateral symmetrical with a substantially L shape and extends from the right side of FIG. 2 of the semiconductor element module 13c.

With this configuration, the AC side output terminal conductor 23b is positioned on the obliquely upper side of the AC side output terminal conductor 23a, the AC side output terminal conductor 23c is positioned on the lower side of the AC side output terminal conductor 23b, and the AC side output terminal conductor 23d is positioned on the obliquely upper side of the AC side output terminal conductor 23c. Consequently, as long an insulation distance as possible can be ensured while making the differences in inductance among the AC side output terminal conductors 23 small. From the foregoing, the power converter for a vehicle having the configuration of the present embodiment can achieve downsizing and energy saving.

### Second Embodiment

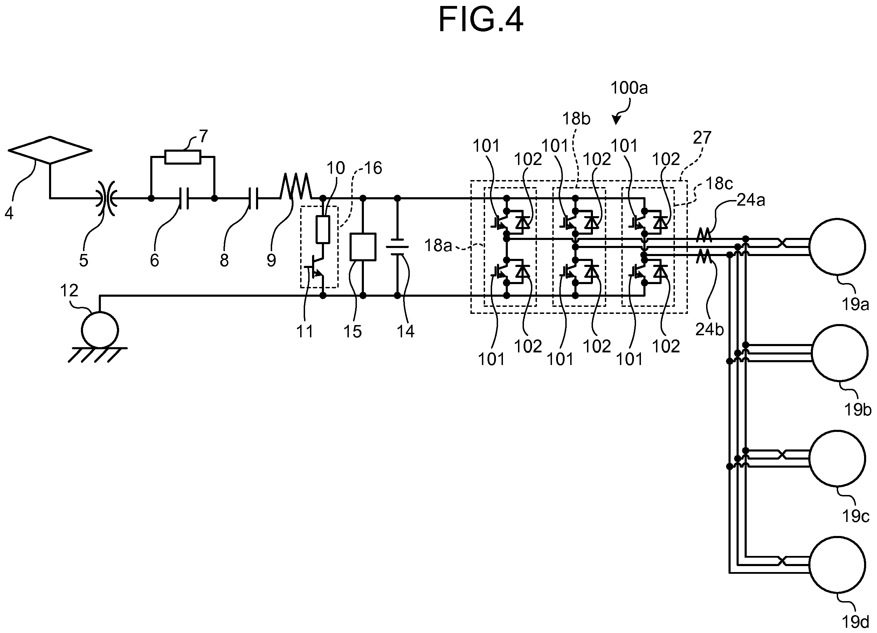

FIG. 4 is a diagram illustrating an example of a circuit configuration of a power converter 100a for a vehicle according to a second embodiment. As illustrated in FIG. 4, the power converter 100a for a vehicle has a circuit configuration that performs three-phase AC output by power from DC overhead electricity (not illustrated) and has a configuration of 1C4M that drives induction motors 19a, 19b, 19c, and 19d that are connected to the power converter 100a for a vehicle in parallel.

A main circuit configuration of the power converter 100a for a vehicle includes the pantograph 4, the high-speed breaker 5, the charging resistor short-circuiting contactor 6, the open contactor 8, the filter reactor 9, the filter capacitor 14, the filter capacitor voltage detector 15, the filter capacitor discharge unit 16 (including the filter capacitor discharge resistor 10 and the switching element 11 for discharge), 2 in1 semiconductor element modules 18a, 18b, and 18c, a cooling unit 27 that cools the semiconductor element modules, the wheel 12, the induction motors 19a, 19b, 19c, and 19d, and current detectors 24a and 24b.

Similarly to the cooling unit 1, the cooling unit 27 radiates heat generated by the semiconductor element modules 18a, 18b, and 18c from a heat radiating unit through a coolant or the like, thereby cooling the semiconductor element modules 18a, 18b, and 18c.

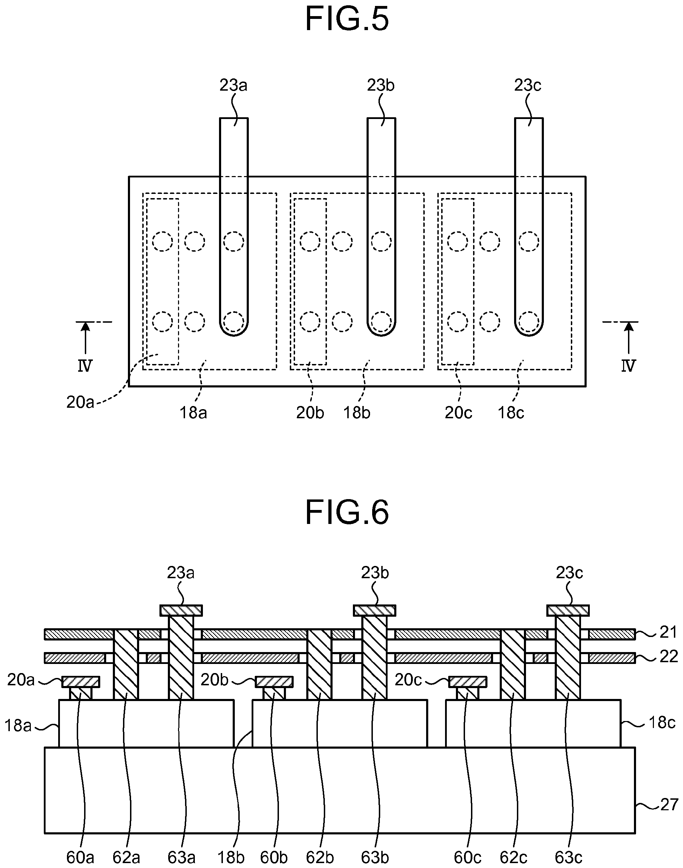

The semiconductor element modules 18a, 18b, and 18c include the switching elements 101 that perform switching operation based on voltages applied to gates by the gate driver circuit boards 20a, 20b, and 20c (refer to FIGS. 5 and 6) and the freewheeling diodes 102 that pass a freewheeling current. Specifically, the semiconductor element modules 18a, 18b, and 18c have circuits, each of which is related to single-phase AC output and having arms each of which connects the freewheeling diode 102 anti-parallel to the switching element 101, the arms being connected in series and has a configuration of 2in1 that incorporates two switching elements 101 into one circuit module. In the power converter 100a for a vehicle, the semiconductor element modules 18a, 18b, and 18c with a configuration of 2in1 perform three-phase AC output for driving the induction motors 19a, 19b, 19c, and 19d connected in parallel. The semiconductor element modules 18a, 18b, and 18c with a configuration of 2in1 are mounted on the cooling unit 27.

Silicon carbide (SiC), not Si, is included in the switching elements 101 and the freewheeling diodes 102 of the semiconductor element modules 18a, 18b, and 18c. Consequently, for the same reason as for the power converter 100 for a vehicle, the power converter 100a for a vehicle, which drives the four induction motors 19a, 19b, 19c, and 19d in parallel, can incorporate up to two switching elements 101 with a current rating of 1,500 A into one of the semiconductor element modules 18a, 18b, and 18c, and downsizing of the inverter can be achieved.

FIG. 5 is a diagram illustrating mounting of the semiconductor element modules 18a, 18b, and 18c on the cooling unit 27. FIG. 6 is a IV-IV sectional view in FIG. 5.

As illustrated in FIG. 5 and FIG. 6, the semiconductor element modules 18a, 18b, and 18c are arranged on the same cooling face (the top face of the cooling unit 27 in the illustrated example) that the cooling unit 27 provides cooling. On the semiconductor element modules 18a, 18b, and 18c, the gate driver circuit boards 20a, 20b, and 20c, the positive electrode side laminate conductor 21, and the negative electrode side laminate conductor 22 are arranged in substantially parallel to the semiconductor element modules 18a, 18b, and 18c. The semiconductor element modules 18a, 18b, and 18c, the gate driver circuit boards 20a, 20b, and 20c, the positive electrode side laminate conductor 21, the negative electrode side laminate conductor 22, and the AC side output terminal conductors 23a, 23b, and 23c are connected to each other via connecting bushes.

Specifically, as illustrated in FIG. 6, the semiconductor element module 18a and the gate driver circuit board 20a are connected to each other via a connecting bush 60a. The semiconductor element module 18a and the positive electrode side laminate conductor 21 are connected to each other via a connecting bush 62a. The semiconductor element module 18a and the AC side output terminal conductor 23a are connected to each other via a connecting bush 63a. Similarly, the semiconductor element module 18b and the gate driver circuit board 20b, the semiconductor element module 18b and the positive electrode side laminate conductor 21, and the semiconductor element module 18b and the AC side output terminal conductor 23b are connected to each other via connecting bushes 60b, 62b, and 63b, respectively. The semiconductor element module 18c and the gate driver circuit board 20c, the semiconductor element module 18c and the positive electrode side laminate conductor 21, and the semiconductor element module 18c and the AC side output terminal conductor 23c are connected to each other via connecting bushes 60c, 62c, and 63c, respectively.

The gate driver circuit boards 20a, 20b, and 20c are thus directly connected to the semiconductor element modules 18a, 18b, and 18c, respectively, via the connecting bushes, thereby reducing gate control wiring and increasing the responsiveness of gate control. The positive electrode side laminate conductor 21 and the negative electrode side laminate conductor 22 are connected to the semiconductor element modules 18a, 18b, and 18c via the connecting bushes to share the positive electrode side laminate conductor 21 and the negative electrode side laminate conductor 22 by the three element modules, thereby reducing inductance with the filter capacitor 14 and increasing cutoff characteristics in the switching element 101.

In this situation, the AC side output terminal conductors 23 have substantially the same length. Consequently, inductances, which are proportional to the conductor lengths, are also substantially the same, and handling in terms of control is easy. The respective gate driver circuit boards 20 on the respective semiconductor element modules 18 are positioned on the respective ends opposite to the respective ends from which the respective AC side output terminal conductors 23 of the respective semiconductor element modules 18 extend. Thus, distances are ensured between the respective AC side output terminal conductors 23 and the respective gate driver circuit boards 20, and the influence of noise occurring from the respective AC side output terminal conductors 23 on the respective gate driver circuit boards 20 can be reduced. From the foregoing, the power converter for a vehicle having the configuration of the present embodiment can achieve downsizing and energy saving.

### Third Embodiment

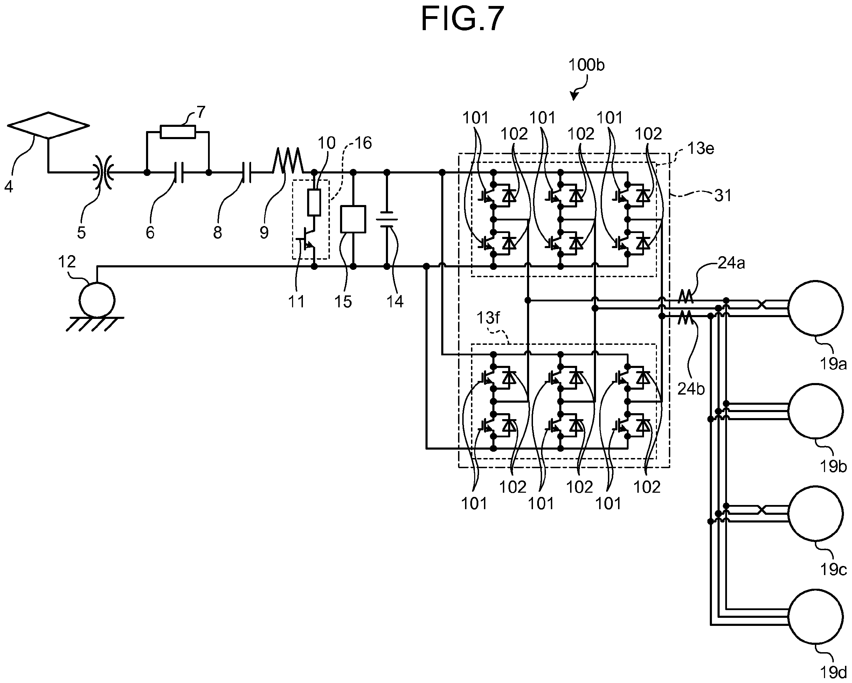

FIG. 7 is a diagram illustrating an example of a circuit configuration of a power converter 100b for a vehicle according to a third embodiment. As illustrated in FIG. 7, the power converter 100b for a vehicle has a circuit configuration that performs three-phase AC output by power from DC overhead electricity (not illustrated) and has a configuration of 1C4M that drives the induction motors 19a, 19b, 19c, and 19d that are connected to the power converter 100b for a vehicle in parallel.

A main circuit configuration of the power converter 100b for a vehicle includes the pantograph 4, the high-speed breaker 5, the charging resistor short-circuiting contactor 6, the open contactor 8, the filter reactor 9, the filter capacitor 14, the filter capacitor voltage detector 15, the filter capacitor discharge unit 16 (including the filter capacitor discharge resistor 10 and the switching element 11 for discharge), 6in1 semiconductor element modules 13e and 13f, a cooling unit 31 that cools the semiconductor element modules, the wheel 12, the induction motors 19a, 19b, 19c, and 19d, and the current detectors 24a and 24b.

Similarly to the cooling unit 1, the cooling unit 31 radiates heat generated by the semiconductor element modules 13e and 13f from a heat radiating unit through a coolant or the like, thereby cooling the semiconductor element modules 13e and 13f.

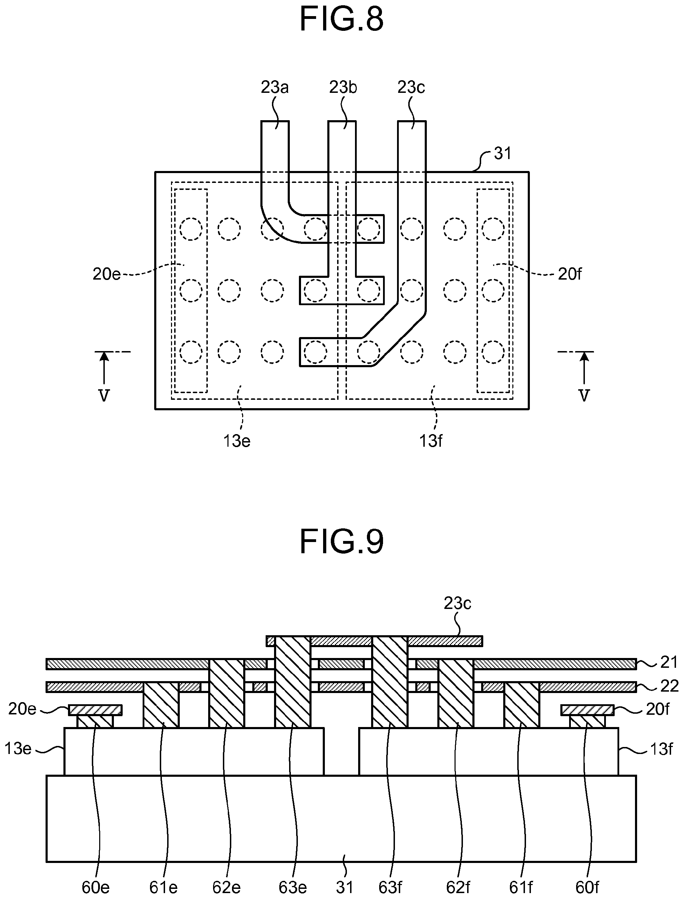

The semiconductor element modules 13e and 13f include the switching elements 101 that perform switching operation based on voltages applied to gates by gate driver circuit boards 20e and 20f (refer to FIGS. 8 and 9) and the freewheeling diodes 102 that pass a freewheeling current. Specifically, the semiconductor element modules 13e and 13f have circuits for three phases, each of the circuits being related to single-phase AC output and having arms each of which connects the freewheeling diode 102 anti-parallel to the switching element 101, the arms being connected in series. In other words, the semiconductor element modules 13e and 13f have a configuration of 6in1 that incorporates six switching elements 101 into one circuit module. The semiconductor element module 13e and the semiconductor element module 13f are connected in parallel and from their neutral points perform three-phase AC output for driving the induction motors 19a, 19b, 19c, and 19d connected in parallel.

The current rating of the semiconductor element modules 13e and 13f with a configuration of 6in1 is about 500 A, and by connecting the semiconductor element module 13e and the semiconductor element module 13f in parallel to constitute a rating equivalent to 1,000 A, the induction motors 19a, 19b, 19c, and 19d connected in parallel can be driven. SiC, not Si, is included in the switching elements 101 and the freewheeling diodes 102 of the semiconductor element modules 13e and 13f. Consequently, for the same reason as for the power converter 100 for a vehicle, downsizing of the inverter can be achieved.

FIG. 8 is a diagram illustrating mounting of the semiconductor element modules 13e and 13f on the cooling unit 31. FIG. 9 is a V-V sectional view in FIG. 8.

As illustrated in FIG. 8 and FIG. 9, the semiconductor element modules 13e and 13f are arranged on the same cooling face (the top face of the cooling unit 31 in the illustrated example) that the cooling unit 31 provides cooling. On the semiconductor element modules 13e and 13f, the gate driver circuit boards 20e and 20f, the positive electrode side laminate conductor 21, and the negative electrode side laminate conductor 22 are arranged in substantially parallel to the semiconductor element modules 13e and 13f. The semiconductor element modules 13e and 13f, the gate driver circuit boards 20e and 20f, the positive electrode side laminate conductor 21, the negative electrode side laminate conductor 22, and the AC side output terminal conductors 23a, 23b, and 23c are connected to each other via connecting bushes.

Specifically, as illustrated in FIG. 9, the semiconductor element module 13e and the gate driver circuit board 20e are connected to each other via a connecting bush 60e. The semiconductor element module 13e and the negative electrode side laminate conductor 22 are connected to each other via a connecting bush 61e. The semiconductor element module 13e and the positive electrode side laminate conductor 21 are connected to each other via a connecting bush 62e. The semiconductor element module 13e and the AC side output terminal conductor 23c are connected to each other via a connecting bush 63e. Similarly, the semiconductor element module 13f and the gate driver circuit board 20f, the semiconductor element module 13f and the negative electrode side laminate conductor 22, the semiconductor element module 13f and the positive electrode side laminate conductor 21, and the semiconductor element module 13f and the AC side output terminal conductor 23c are connected to each other via connecting bushes 60f, 61f, 62f, and 63f, respectively. It is apparent that the AC side output terminal conductors 23a and 23b are also, similarly, connected via connecting bushes.

The gate driver circuit boards 20e and 20f are thus directly connected to the semiconductor element modules 13e and 13f, respectively, via the connecting bushes, thereby reducing gate control wiring and increasing the responsiveness of gate control. The positive electrode side laminate conductor 21 and the negative electrode side laminate conductor 22 are connected to the semiconductor element modules 13e and 13f via the connecting bushes to share the positive electrode side laminate conductor 21 and the negative electrode side laminate conductor 22 by the two element modules, thereby reducing inductance with the filter capacitor 14 and increasing cutoff characteristics in the switching element 101.

### Fourth Embodiment

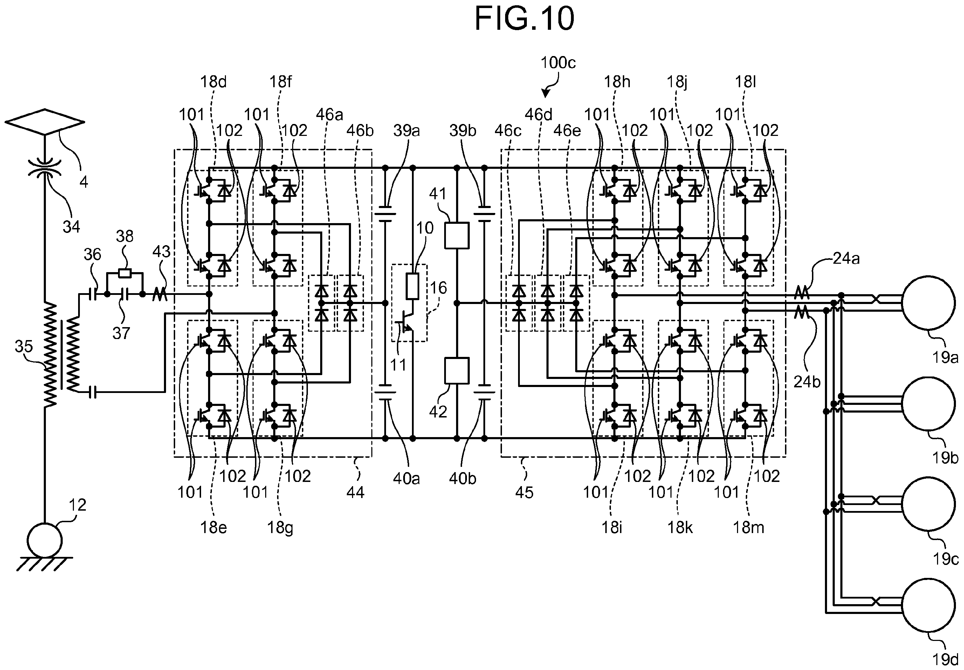

FIG. 10 is a diagram illustrating an example of a circuit configuration of a power converter 100c for a vehicle according to a fourth embodiment. As illustrated in FIG. 10, the power converter 100c for a vehicle has a configuration that includes semiconductor element modules 18d, 18e, 18f, and 18g for a converter including circuits each having arms each of which connects the freewheeling diode 102 anti-parallel to the switching element 101, the arms being connected in series and has a three-level single-phase converter that obtains DC output from input single-phase AC using the semiconductor element modules 18d, 18e, 18f, and 18g.

A main circuit configuration of the power converter 100c for a vehicle includes the pantograph 4, a high-speed breaker 34, a main transformer 35, a charging resistor 38, a charging resistor short-circuiting contactor 37, an open contactor 36, positive electrode side filter capacitors 39a and 39b, negative electrode side filter capacitors 40a and 40b, a positive electrode side filter capacitor voltage detector 41, a negative electrode side filter capacitor voltage detector 42, the filter capacitor discharge unit 16 (including the filter capacitor discharge resistor 10 and the switching element 11 for discharge), semiconductor element modules 18d, 18e, 18f, and 18g for a 2in1 converter, neutral point clamping diodes 46a and 46b, a cooling unit 44 that cools the semiconductor element modules and the neutral point clamping diodes, semiconductor element modules 18h, 18i, 18j, 18k, 181, and 18m for a 2in1 inverter, neutral point clamping diodes 46c, 46d, and 46e, a cooling unit 45 that cools the semiconductor element modules and the neutral point clamping diodes, the wheel 12, the induction motors 19a, 19b, 19c, and 19d, the current detectors 24a and 24b, and a converter input current detector 43.

Specifically, the pantograph 4 that collects electricity from AC overhead electricity (not illustrated) is connected to the wheel 12 via the high-speed breaker 34 and the main transformer 35. Output from the secondary coil of the main transformer 35 is input to the three-level single-phase converter using the semiconductor element modules 18d, 18e, 18f, and 18g via the open contactor 36, the charging resistor short-circuiting contactor 37, the charging resistor 38, and the converter input current detector 43. Output of the three-level single-phase converter using the semiconductor element modules 18d, 18e, 18f, and 18g is input to the semiconductor element modules 18h, 18i, 18j, 18k, 181, and 18m for an inverter via an intermediate DC circuit including the positive electrode side filter capacitor 39a, the negative electrode side filter capacitor 40a, the filter capacitor discharge unit 16, the positive electrode side filter capacitor voltage detector 41, the negative electrode side filter capacitor voltage detector 42, the positive electrode side filter capacitor 39b, and the negative electrode side filter capacitor 40b. In an inverter unit, a three-level three-phase inverter is constituted using the semiconductor element modules 18h, 18i, 18j, 18k, 181, and 18m for an inverter including circuits each having arms each of which connects the freewheeling diode 102 anti-parallel to the switching element 101, the arms being connected in series. From this inverter unit, three-phase AC output for driving the induction motors 19a, 19b, 19c, and 19d connected in parallel is performed.

When the power converter 100c for a vehicle is started, the high-speed breaker 34 is turned on, the open contactor 36 is turned on, and then the positive electrode side filter capacitors 39a and 39b and the negative electrode side filter capacitors 40a and 40b are charged from the AC overhead electricity via the charging resistor 38 and the freewheeling diodes 102 of the semiconductor element modules 18d, 18e, 18f, and 18g. When the charge to the positive electrode side filter capacitors 39a and 39b and the negative electrode side filter capacitors 40a and 40b is completed, the charging resistor short-circuiting contactor 37 is turned on, a gate signal (gate voltage) is output to the semiconductor element modules 18d, 18e, 18f, and 18g for a converter, and the single-phase converter starts its operation. Similarly, the inverter unit also starts its operation after a gate signal is output to the semiconductor element modules 18h, 18i, 18j, 18k, 181, and 18m for an inverter.

SiC, not Si, is included in the switching elements 101 and the freewheeling diodes 102 of the semiconductor element modules 18d, 18e, 18f, and 18g for a converter, and the neutral point clamping diodes 46a and 46b that clamp neutral points. Consequently, for the same reason as for the power converter 100 for a vehicle, downsizing of the converter unit of the power converter 100c for a vehicle can be achieved. Similarly, SiC, not Si, is included in the switching elements 101 and the freewheeling diodes 102 of the semiconductor element modules 18h, 18i, 18j, 18k, 181, and 18m for an inverter and the neutral point clamping diodes 46c, 46d, and 46e that clamp neutral points. Consequently, for the same reason as for the power converter 100 for a vehicle, downsizing of the inverter unit can be achieved. SiC is also included in the neutral point clamping diodes 46a, 46b, 46c, 46d, and 46e that clamp the neutral points, thereby reducing generation losses.

### Modification 1

The following describes modifications of the first to fourth embodiments. In the above embodiments, the conductors (the AC side output terminal conductors 23a, 23b, 23c, and 23d in FIG. 2, FIG. 5, and FIG. 8 or the like) that perform AC output from the respective semiconductor element modules extend in parallel with the face on which the semiconductor element modules are arranged. In contrast, Modification 1 exemplifies a configuration in which the conductors that perform AC output from the respective semiconductor element modules extend substantially perpendicularly to the face on which the semiconductor element modules are arranged as a modification of the first embodiment.

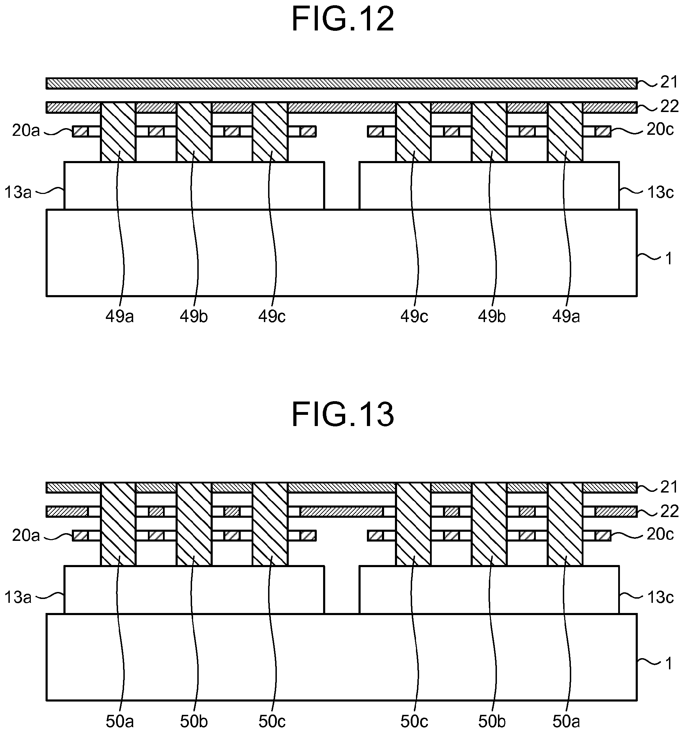

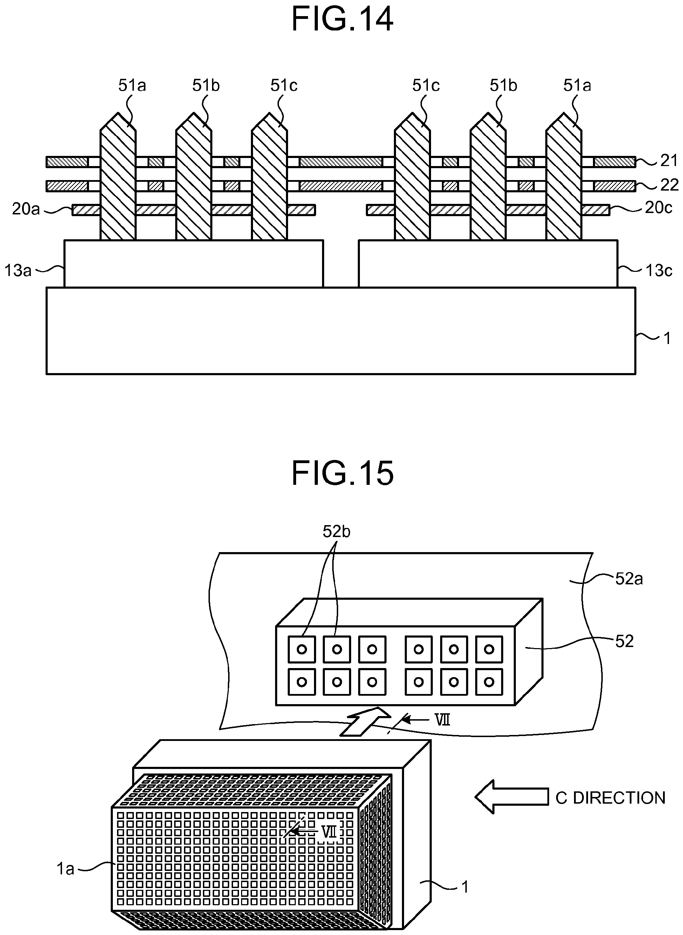

FIG. 11 is a diagram exemplifying an appearance of a power converter for a vehicle according to Modification 1. FIG. 12 is a VIa-VIa sectional view in FIG. 11. FIG. 13 is a VIb-VIb sectional view in FIG. 11. FIG. 14 is a VIc-VIc sectional view in FIG. 11.

As illustrated in FIG. 11 and FIG. 14, in Modification 1, three-phase AC output from the semiconductor element modules 13a, 13b, 13c, and 13d is performed by AC side output terminal conductors 51a, 51b, and 51c that penetrate the positive electrode side laminate conductor 21 and the negative electrode side laminate conductor 22 and extend substantially perpendicularly to the face on which the semiconductor element modules 13a, 13b, 13c, and 13d are arranged.

As illustrated in FIG. 12, the semiconductor element modules 13a and 13c and the negative electrode side laminate conductor 22 are connected via connecting bushes 49a, 49b, and 49c. As illustrated in FIG. 13, the semiconductor element modules 13a and 13c and the positive electrode side laminate conductor 21 are connected via connecting bushes 50a, 50b, and 50c. It is apparent that the semiconductor element modules 13b and 13d are also connected via connecting bushes.

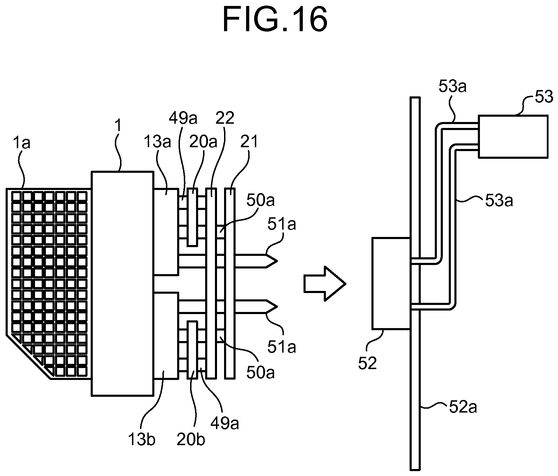

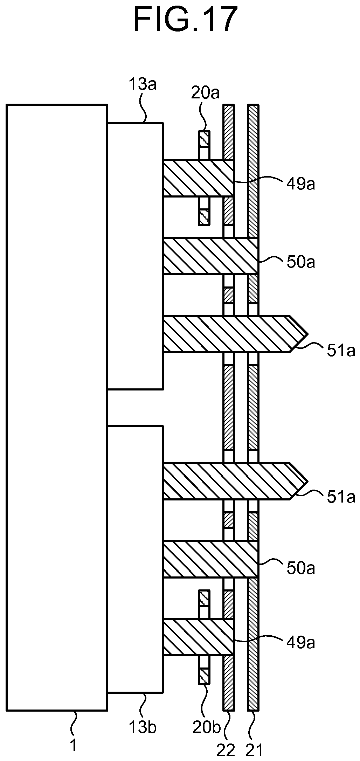

FIG. 15 is a conceptual diagram exemplifying connection to a terminal unit 52. FIG. 16 is a side view from the C direction in FIG. 15. FIG. 17 is a VII-VII sectional view in FIG. 15. As illustrated in FIG. 15 to FIG. 17, in Modification 1, the ends of the AC side output terminal conductors 51a, 51b, and 51c are inserted into conductor receivers 52b of the terminal unit 52 mounted on a support plate 52a, thereby performing the three-phase AC output from the semiconductor element modules 13a, 13b, 13c, and 13d by an output connector 53 via wiring 53a. In this case, the three-phase AC output via the wiring 53a is shielded by the support plate 52a and does not affect the semiconductor element modules.

As described above, the three-phase AC output from the semiconductor element modules 13a, 13b, 13c, and 13d is performed by the AC side output terminal conductors 51a, 51b, and 51c that extend substantially perpendicularly to the face on which the semiconductor element modules 13a, 13b, 13c, and 13d are arranged through direct connection to the terminal unit 52, and the influence of noise by the three-phase AC output on the semiconductor element modules 13a, 13b, 13c, and 13d can be reduced. For example, as is clear from comparison with the case in FIG. 2, the influence of the noise by the three-phase AC output on the gate driver circuit boards can be reduced. From the foregoing, the power converter for a vehicle having the configuration of the present embodiment can achieve downsizing and energy saving.

### Modification 2

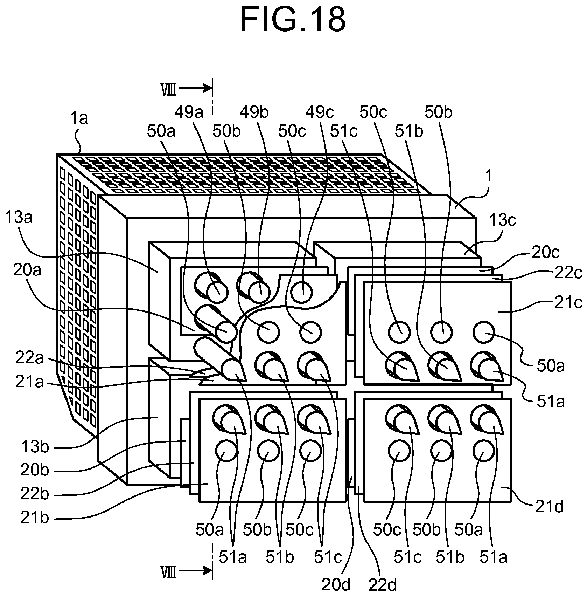

FIG. 18 is a diagram exemplifying an appearance of a power converter for a vehicle according to Modification 2. As illustrated in FIG. 18, Modification 2 is different from Modification 1 in that it has a configuration in which the semiconductor element modules 13a, 13b, 13c, and 13d are independent of each other.

Specifically, the semiconductor element module 13a is connected to a negative electrode side laminate conductor 22a via the connecting bushes 49a, 49b, and 49c and is connected to a positive electrode side laminate conductor 21a via the connecting bushes 50a, 50b, and 50c. Similarly, the semiconductor element module 13b is connected to a positive electrode side laminate conductor 21b and a negative electrode side laminate conductor 22b via connecting bushes. The semiconductor element module 13c is connected to a positive electrode side laminate conductor 21c and a negative electrode side laminate conductor 22c via connecting bushes. The semiconductor element module 13d is connected to a positive electrode side laminate conductor 21d and a negative electrode side laminate conductor 22d via connecting bushes. Thus, in the configuration in which the semiconductor element modules 13a, 13b, 13c, and 13d are independent of each other, even when damage or the like occurs in any semiconductor element module, influence on the other semiconductor element modules can be reduced, and redundancy can be increased.

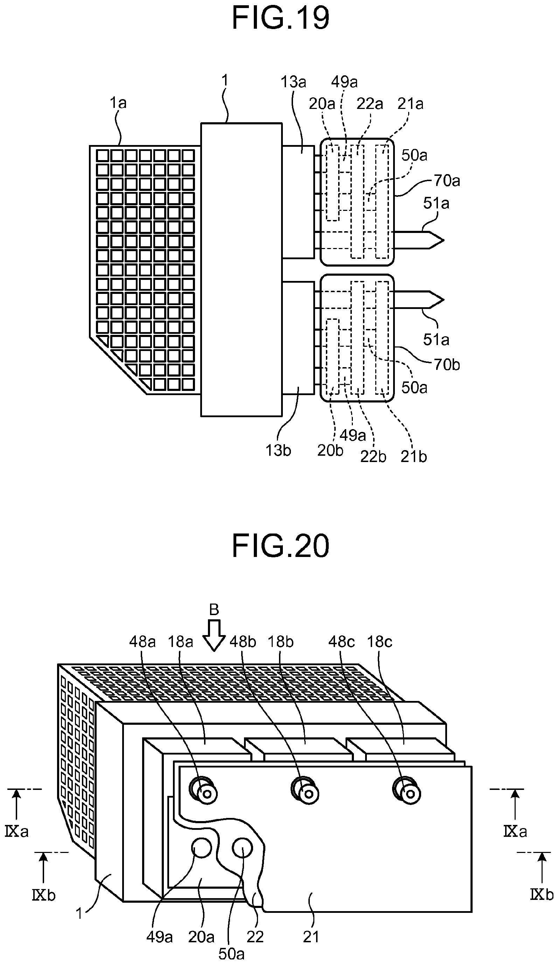

FIG. 19 is an VIII-VIII sectional view in FIG. 18 in the case of resin-sealing with a mold resin. As illustrated in FIG. 19, the gate driver circuit board 20a, the negative electrode side laminate conductor 22a, and the positive electrode side laminate conductor 21a that are arranged on the semiconductor element module 13a may be resin-sealed with a mold resin 70a to be integrated except an output side end of the AC side output terminal conductor 51a. The gate driver circuit board 20b, the negative electrode side laminate conductor 22b, and the positive electrode side laminate conductor 21b that are arranged on the semiconductor element module 13b may also, similarly, be resin-sealed with a mold resin 70b to be integrated except an output side end of the AC side output terminal conductor 51a. It is apparent that the semiconductor element modules 13c and 13d are also, similarly, be resin-sealed. The mold resin 70a is an insulating thermosetting resin such as epoxy.

By thus resin-sealing the gate driver circuit board, the negative electrode side laminate conductor, and the positive electrode side laminate conductor with the insulating resin, a low voltage part of the gate driver circuit board, the negative electrode side laminate conductor, and the positive electrode side laminate conductor are separated from each other by the insulator, and thus ensuring withstand voltage of a high voltage part and the low voltage part and causing the low voltage part less likely to be subjected to noise or the like from the high voltage part. From the foregoing, the power converter for a vehicle having the configuration of the present embodiment can achieve downsizing and energy saving.

### Modification 3

Modification 3 exemplifies a configuration in which the conductors that perform AC output from the respective semiconductor element modules extend substantially perpendicularly to the face on which the semiconductor element modules are arranged as a modification of the second embodiment.

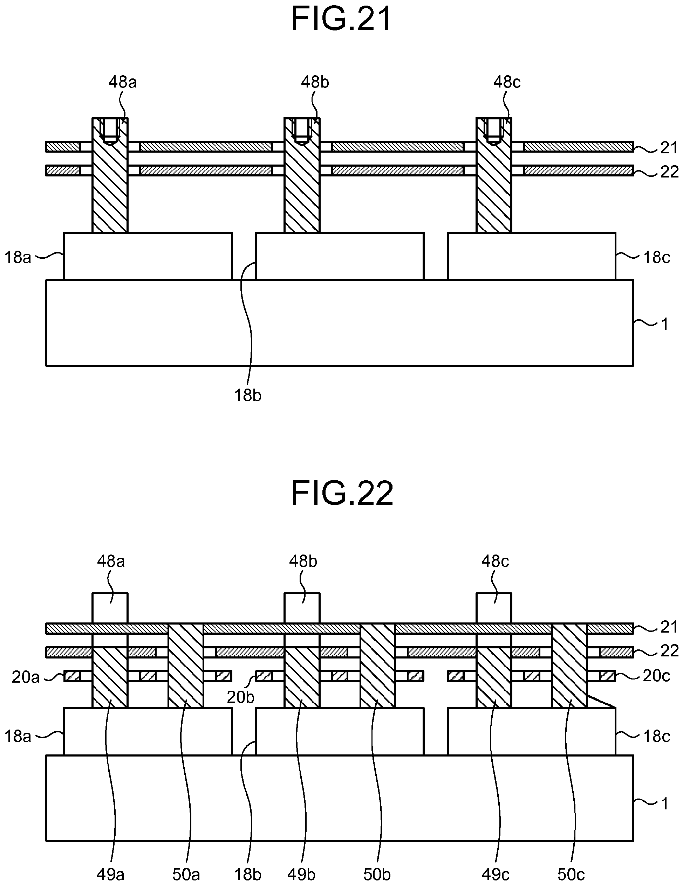

FIG. 20 is a diagram exemplifying an appearance of a power converter for a vehicle according to Modification 3. FIG. 21 is an IXa-IXa sectional view in FIG. 20. FIG. 22 is a IXb-IXb sectional view in FIG. 20.

As illustrated in FIG. 20 to FIG. 22, in Modification 3, three-phase AC output from the semiconductor element modules 18a, 18b, and 18c is performed by AC side output terminal conductors 48a, 48b, and 48c that penetrate the positive electrode side laminate conductor 21 and the negative electrode side laminate conductor 22 and extend substantially perpendicularly to the face on which the semiconductor element modules 18a, 18b, and 18c are arranged.

As illustrated in FIG. 22, the semiconductor element modules 18a, 18b, and 18c and the negative electrode side laminate conductor 22 are connected via the connecting bushes 49a, 49b, and 49c. The semiconductor element modules 18a, 18b, and 18c and the positive electrode side laminate conductor 21 are connected via the connecting bushes 50a, 50b, and 50c. It is apparent that the gate driver circuit boards 20a, 20b, and 20c are also, similarly, connected via connecting bushes.

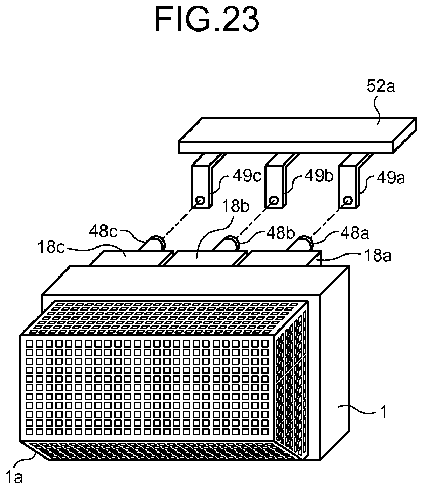

FIG. 23 is conceptual diagram exemplifying connection to a conductor receiver 52c. As illustrated in FIG. 23, in Modification 3, the ends of the AC side output terminal conductors 48a, 48b, and 48c are screwed into holes of conductor receivers 49a, 49b, and 49c mounted on the support plate 52a, thereby performing the three-phase AC output from the semiconductor element modules 18a, 18b, and 18c.

As described above, the three-phase AC output may be performed by causing the AC side output terminal conductors 48a, 48b, and 48c that extend substantially perpendicularly to the face on which the semiconductor element modules 18a, 18b, and 18c are arranged to be screwed into the conductor receivers 49a, 49b, and 49c.

The present invention is not limited to the above embodiments as they are and can be embodied with the components modified without departing from the essence thereof in the stage of implementation. Appropriate combinations of a plurality of components disclosed in the embodiments can form various inventions. For example, some components may be deleted from all components disclosed in the embodiments. Furthermore, components across different embodiments may appropriately be combined.

While the foregoing describes the embodiments of the present invention, these embodiments are presented as examples and do not intend to limit the scope of the invention. Variations and modifications are possible within the scope of the appended claims.

## Claims

1. A power converter (100; 100a; 100b; 100c) for a vehicle comprising:
a plurality of semiconductor element modules (13a, 13b, 13c, 13d; 13e, 13f; 18a, 18b, 18c) for an inverter that each include a switching element (101) and a freewheeling diode (102) and form circuits for three phases as circuits that perform three-phase AC output for driving one permanent magnet synchronous motor (2), the switching element (101) using silicon carbide (SiC) and performing switching operation, the freewheeling diode (102) using silicon carbide (SiC) and passing a freewheeling current, each of the circuits being related to single-phase AC output and having arms each of which connects the freewheeling diode (102) anti-parallel to the switching element (101), the arms being connected in series;
a cooling unit (1, 27, 31) that cools the semiconductor element modules (13a, 13b, 13c, 13d; 13e, 13f; 18a, 18b, 18c) for the inverter;
two conductor plates (21, 22) that have positive electrode side (21) and negative electrode side (22), are arranged on the semiconductor element modules (13a, 13b, 13c, 13d; 13e, 13f; 18a, 18b, 18c) for the inverter in substantially parallel to the semiconductor element modules (13a, 13b, 13c, 13d; 13e, 13f; 18a, 18b, 18c) for the inverter, and are connected to the semiconductor element modules (13a, 13b, 13c, 13d; 13e, 13f; 18a, 18b, 18c) for the inverter via connecting bushes (61b, 62b, 61d, 62d);
a gate driver circuit (20a, 20b, 20c, 20d) that controls a gate voltage of the switching element (101); and
conductors (23; 51a, 51b, 51c) that perform AC output from the semiconductor element modules (13a, 13b, 13c, 13d; 13e, 13f; 18a, 18b, 18c) for the inverter, wherein
the semiconductor element modules (13a, 13b, 13c, 13d; 13e, 13f; 18a, 18b, 18c) for the inverter are arranged on a cooling face to which the cooling unit (1, 27, 31) provides cooling,
**characterized in that**
the conductors (23; 51a, 51b, 51c) penetrate the two conductor plates (21, 22) and extend in a direction substantially perpendicular to a face on which the semiconductor element modules (13a, 13b, 13c, 13d; 13e, 13f; 18a, 18b, 18c) for the inverter are arranged, the ends of the AC side output terminal conductors (23; 51a, 51b, 51c) are inserted into conductor receivers (52b) of a terminal unit (52) mounted on a support plate (52a), thereby performing the three-phase AC output from the semiconductor element modules (13a, 13b, 13c, 13d; 13e, 13f; 18a, 18b, 18c) by an output connector (53) via wiring (53a).

## Patentansprüche

1. Leistungswandler (100; 100a; 100b; 100c) für ein Fahrzeug, umfassend:
mehrere Halbleiterelementmodule (13a, 13b, 13c, 13d; 13e, 13f; 18a, 18b, 18c) für einen Wechselrichter, die jeweils ein Schaltelement (101) und eine Freilaufdiode (102) aufweisen und Schaltungen für drei Phasen als Schaltungen bilden, die eine Dreiphasenwechselstrom-Ausgabe zum Antreiben eines Permanentmagnet-Synchronmotors (2) durchführen, wobei das Schaltelement (101) Siliciumcarbid (SiC) verwendet und den Schaltvorgang durchführt, wobei die Freilaufdiode (102) Siliciumcarbid (SiC) verwendet und einen Freilaufstrom leitet, wobei jede der Schaltungen in Verbindung mit einer Einphasenwechselstromausgabe steht und Arme aufweist, die die Freilaufdiode (102) jeweils antiparallel zu dem Schaltelement (101) anschließen, wobei die Arme in Reihe geschaltet sind;
eine Kühleinheit (1, 27, 31), die die Halbleiterelementmodule (13a, 13b, 13c, 13d; 13e, 13f; 18a, 18b, 18c) für den Wechselrichter kühlt;
zwei Leiterplatten (21, 22), die eine Seite (21) der positiven Elektrode und eine Seite (22) der negativen Elektrode aufweisen, die auf den Halbleiterelementmodulen (13a, 13b, 13c, 13d; 13e, 13f; 18a, 18b, 18c) für den Wechselrichter, im Wesentlichen parallel zu den Halbleiterelementmodulen (13a, 13b, 13c, 13d; 13e, 13f; 18a, 18b, 18c) für den Wechselrichter, angeordnet sind und mit den Halbleiterelementmodulen (13a, 13b, 13c, 13d; 13e, 13f; 18a, 18b, 18c) für den Wechselrichter über Anschlussbuchsen (61b, 62b, 61d, 62d) verbunden sind;
eine Gate-Treiberschaltung (20a, 20b, 20c, 20d), die eine Gate-Spannung des Schaltelements (101) steuert; und
Leiter (23; 51a, 51b, 51c), die eine Wechselstromausgabe aus den Halbleiterelementmodulen (13a, 13b, 13c, 13d; 13e, 13f; 18a, 18b, 18c) für den Wechselrichter durchführen, wobei
die Halbleiterelementmodule (13a, 13b, 13c, 13d; 13e, 13f; 18a, 18b, 18c) für den Wechselrichter auf einer Kühlfläche angeordnet sind, die durch die Kühleinheit (1, 27, 31) gekühlt wird,
**dadurch gekennzeichnet, dass**
die Leiter (23; 51a, 51b, 51c) die zwei Leiterplatten (21, 22) durchdringen und sich in einer Richtung erstrecken, die im Wesentlichen senkrecht zu einer Fläche ist, auf der die Halbleiterelementmodule (13a, 13b, 13c, 13d; 13e, 13f; 18a, 18b, 18c) für den Wechselrichter angeordnet sind,
die Enden der wechselstromseitigen Ausgangsanschlussleiter (23; 51a, 51b, 51c) in Leiteraufnahmen (52b) einer Anschlusseinheit (52), die an einer Tragplatte (52a) befestigt ist, eingesetzt sind, wodurch die Dreiphasenwechselstrom-Ausgabe aus den Halbleiterelementmodulen (13a, 13b, 13c, 13d; 13e, 13f; 18a, 18b, 18c) durch einen Ausgangsstecker (53) über eine Verdrahtung (53a) durchgeführt wird.

## Revendications

1. Convertisseur de puissance (100;100a;100b;100c) pour un véhicule comprenant :
une pluralité de modules d'éléments à semi-conducteurs (13a,13b,13c,13d ;13e,13f ;18a,18b,18c) pour un onduleur qui incluent chacun un élément de commutation (101) et une diode de roue libre (102) et forment des circuits pour trois phases comme des circuits qui exécutent une sortie triphasée CA pour attaquer un moteur synchrone à aimant permanent (2), l'élément de commutation (101) utilisant du carbure de silicium (SiC) effectuant une opération de commutation, la diode de roue libre (102) utilisant du carbure de silicium (SiC) et laissant passer un courant de roue libre, chacun des circuits étant relatif à une sortie monophasée CA et ayant des bras dont chacun connecte la diode de roue libre (102) de manière anti parallèle à l'élément de commutation (101), les bras étant connectés en série ;
une unité de refroidissement (1,27,31) qui refroidit les modules d'éléments à semi-conducteurs (13a,13b,13c,13d ;13e,13f ;18a,18b,18c) pour l'onduleur ;
deux plaques conductrices (21,22) qui ont un côté d'électrode positive (21) et un côté d'électrode négative (22), sont disposées sur le module d'éléments à semi-conducteurs (13a,13b,13c,13d ;13e,13f ;18a,18b,18c) pour l'onduleur substantiellement en parallèle au module d'éléments à semi-conducteurs (13a,13b,13c,13d ;13e,13f ;18a,18b,18c) pour l'onduleur et sont connectées au module d'éléments à semi-conducteurs (13a,13b,13c,13d ;13e,13f ;18a,18b,18c) via des brosses de connexion (61b,62b,61d,62d) ;
un circuit d'attaque de grille (20a,20b,20c,20d) qui commande une tension de grille de l'élément de commutation (101) ; et
des conducteurs (23 ;51a,51b,51c) qui exécute une sortie CA à partir des modules d'éléments à semi-conducteurs(13a,13b,13c,13d ;13e,13f ;18a,18b,18c) pour l'onduleur, dans lequel
les modules d'éléments à semi-conducteurs
(13a,13b,13c,13d ;13e,13f ;18a,18b,18c) pour l'onduleur sont disposés de phase de refroidissement vers laquelle l'unité de refroidissement (1,27,31) fournit un refroidissement,
**caractérisé en ce que**
les conducteurs (23 ;51a,51b,51c) pénètrent les deux plaques conductrices (21,22) et s'étendent dans une direction substantiellement perpendiculaire à une face sur laquelle les modules d'éléments à semi-conducteurs (13a,13b,13c,13d ;13e,13f ;18a,18b,18c) pour l'onduleur sont disposés ;
les extrémités des conducteurs de borne de sortie du côté CA (23 ;51a,51b,51c) sont insérés dans des récepteurs de conducteurs (52b) d'une unité de borne (52) monte sur une plaque support (52a) en permettant ainsi la sortie CA triphasée à partir des modules d'éléments à semi-conducteurs (13a,13b,13c,13d ;13e,13f ;18a,18b,18c) par un connecteur de sortie (53) via un câblage (53a).
